# EUROPEAN PATENT APPLICATION

(11) **EP 3 115 593 A1**
(43) Date of publication of application: **11.01.2017**
(21) Application number: 16178158.8
(22) Date of filing: 06.07.2016
(51) Int. Cl.: F02M 63/00, F02M 51/06, F02M 61/16, H01L 41/20

(54) **A FUEL INJECTOR HAVING A MAGNETOSTRICTIVE TRIGGER**

(30) Priority: 07.07.2015 TR 201508428
(71) Applicant: ROBERT BOSCH GMBH, 70442 Stuttgart (DE)
(72) Inventor: Arak, Barkin, Duru 6 Sitesi Daire 6 Nilüfer, Bursa (TR); Kandemir, Duygu, 1 A blok Daire 3 Nilüfer Bursa (TR)

(57) **Abstract**

The present invention relates to a fuel injector (1) having at least one triggering mechanism (10) providing the movement of at least one trigger (50) for spraying the fuel when desired, in order to be used in internal combustion engines. As an improvement, the present invention is characterized in that said triggering mechanism (10) comprises at least one magnetic field generator (30) and at least one actuator (11) made of magnetostrictive material positioned inside the magnetic field of said magnetic field generator (30).

## Description

### TECHNICAL FIELD

The present invention relates to a fuel injector used for spraying fuel into the combustion chamber in internal combustion engines.

### PRIOR ART

Fuel injectors used in internal combustion engines can be produced in pluralities of different types. One of these types is the piezo electric injector. In piezo electric injectors, the length of the material changes by means of the electrical current applied to piezo electric materials used, and thereby the injector fulfills its function. However, when the electrical current applied in piezo electric materials is removed, the material cannot return to its prior length. In order to bring to material to its prior length and thus in order to provide the injector to continue its function, an additional force shall be applied. Moreover, due to the electric storage characteristic of the piezo electric material, current is accumulated thereon, and afterwards, additional energy shall be consumed for discharging said current. Besides, the production of piezo electric materials is difficult, since they are ceramic based products. There shall be a structure comprising pluralities of layers in order to obtain sufficient elongation. This means that a product is obtained whose production is difficult and whose durability is low.

As a result, because of all of the abovementioned problems, an improvement is required in the related technical field.

### BRIEF DESCRIPTION OF THE INVENTION

The present invention relates to a fuel injector, for eliminating the above mentioned disadvantages and for bringing new advantages to the related technical field.

The main object of the present invention is to provide a fuel injector whose robustness is increased.

Another object of the present invention is to provide a fuel injector whose production is facilitated.

In order to realize all of the abovementioned objects and the objects which are to be deducted from the detailed description below, the present invention is a fuel injector having at least one triggering mechanism providing the movement of at least one trigger for spraying the fuel when desired, in order to be used in internal combustion engines. Accordingly, the present invention is characterized in that said said triggering mechanism comprises at least one magnetic field generator element and at least one actuator made of magnetostrictive material positioned inside the magnetic field of said magnetic field generator element. Thus, the length of the actuator is increased thanks to the effect of the magnetic field formed by the magnetic field generator, and the triggering process is realized.

In a preferred embodiment of the subject matter invention, said actuator made of giant magnetostrictive material.

In a preferred embodiment of the subject matter invention, the actuator is stopped onto the trigger from one end and it is stopped onto at least one rigid member, provided inside the fuel injector, from the other end.

In a preferred embodiment of the subject matter invention, the magnetic field generator element is a solenoid wire.

In a preferred embodiment of the subject matter invention, the magnetic field generator element at least partially wraps around the actuator.

In a preferred embodiment of the subject matter invention, the magnetic field generator element extends along the actuator.

In a preferred embodiment of the subject matter invention, at least one frame is provided between the magnetic field generator element and the actuator.

In a preferred embodiment of the subject matter invention, there is least one shell wherein the actuator and magnetic field generator element are positioned.

In a preferred embodiment of the subject matter invention, there is at least one triggering tip provided in protrusion form on the trigger in order to control the movement direction of the trigger, and at least one guide element having at least one guide channel wherein said triggering tip is at least partially placed.

In a preferred embodiment of the subject matter invention, the guide element is provided in the vicinity of one end of the shell.

In a preferred embodiment of the subject matter invention, the guide element is connected to the trigger and it is made of flexible membrane material.

In a preferred embodiment of the subject matter invention, the guide element is made of a rigid material.

In a preferred embodiment of the subject matter invention, there is at least one preload element in order to provide compression of the actuator at a predetermined amount.

In a preferred embodiment of the subject matter invention, the preload element is at least one spring which pushes the actuator towards the rigid member provided inside the fuel injector.

In a preferred embodiment of the subject matter invention, the preload element is provided in the form of a bolt positioned inside the shell.

### BRIEF DESCRIPTION OF THE FIGURES

In Figure 1, the view of the subject matter fuel injector is given.
In Figure 2, a representative view of an alternative embodiment of the subject matter fuel injector is given.
In Figure 3, a representative view of an alternative embodiment of the subject matter fuel injector is given.

### REFERENCE NUMBERS

1 Fuel injector
10 Triggering mechanism
11 Actuator
20 Frame
30 Magnetic field generator
40 Shell
50 Trigger
51 Triggering tip
60 Guide element
61 Guide channel
70 Preload element
80 Support part
90 Rigid member

### THE DETAILED DESCRIPTION OF THE INVENTION

In this detailed description, the subject matter fuel injector (1) is explained with references to examples without forming any restrictive effect only in order to make the subject more understandable.

The subject matter fuel injector (1) comprises at least one triggering mechanism (10) in order to provide fuel to be transferred to the combustion chamber when desired. Said triggering mechanism (10) comprises at least one trigger (50) and at least one actuator (11). Said actuator (11) is stopped to the trigger (50) from one side, and it is connected to at least one rigid member (90), provided inside the fuel injector (1), from the other side. Thus, the movement of the actuator (11) is restricted. The actuator (11) is made of magnetostrictive material. The actuator (11) is preferably made of a material which is classified under the giant magnetostrictive material (GMM) class, preferably Terfenol-D (Tb0.3Dy0.7Fe1.9). There is at least one magnetic field generator (30) which wraps around the actuator (11). Said magnetic field generator (30) is a solenoid wire. The magnetic field generator (30) at least partially extends along the actuator (11). In order to prevent the contact between the magnetic field generator (30) and the actuator (11), there is at least one frame (20) provided in between. Said frame (20) at least partially wraps around the actuator (11). The actuator (11) and the magnetic field generator (30) are positioned in at least one shell (40). There is at least one guide element (60) provided in the vicinity of an end of said shell (40). At least one guide channel (61) is provided on said guide element (60). At least one triggering tip (51), which is provided on the trigger (50), at least partially passes through said guide channel (61).

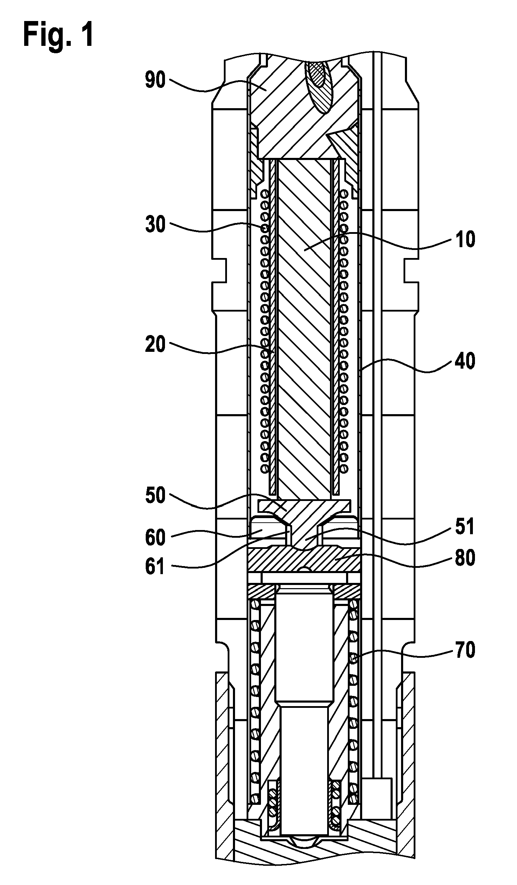

In a probable embodiment of the present invention illustrated in Figure 1, the guide element (60) is made of elastic membrane material. Accordingly, the trigger (50) is preferably welded to the guide element (60). There is at least one preload element (70) provided on the side of the guide element (60) which is opposite with respect to the actuator (11). In said embodiment, said preload element (70) is a spring. The preload element (70) exerts a pressure force to the trigger (50) and thus to the actuator (11) by means of at least one support part (80). In said embodiment, when electrical current is applied to the magnetic field generator (30), a magnetic field is formed. As a result of the effect of said magnetic field, the length of the actuator (11) made of magnetostrictive material is increased. As the length of the actuator (11) is increased, the trigger (50) is pushed. As the trigger (50) is pushed, the guide element (60) bends, and the triggering tip (51), provided on the trigger (50), is displaced. By means of the movement of the triggering tip (51), the movement which provides functioning of the fuel injector (1) is obtained. Thus, the functioning of the fuel injector (1) by using less energy when compared with the prior art is provided. In more details, when electrical current is applied to the magnetic field generator (30), the length of the actuator (11) is increased, and afterwards, the actuator (11) automatically returns to the prior length thereof when the current, applied to the magnetic field generator (30), is removed. Moreover, since the applied current does not directly reach the actuator (11), there remains no unfavorable effect. Moreover, since the actuator (11) is made of metallic material, a robust fuel injector (1) is obtained whose production is facilitated. Since magnetostrictive material is used, it is possible to produce a shorter actuator (11) when compared with the materials existing in the prior art. Thanks to this, it is possible to design a smaller actuator (11) and a smaller fuel injector (1).

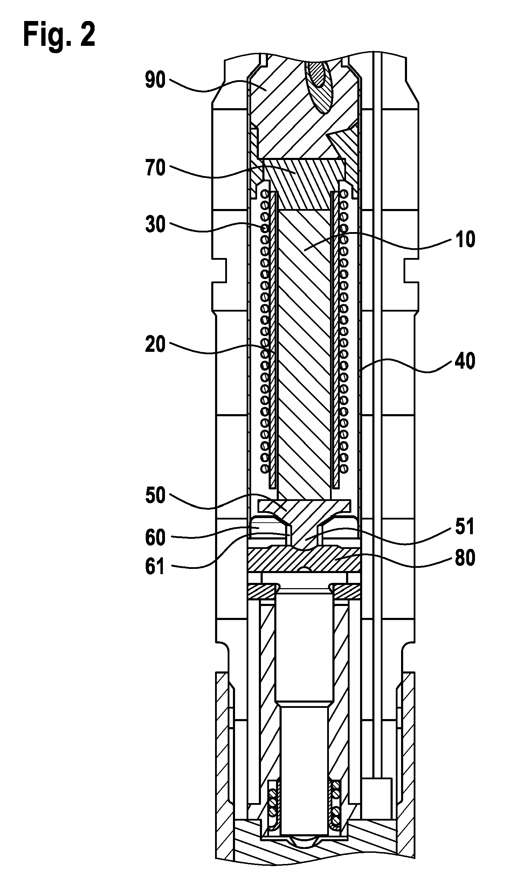

In Figure 2, an alternative embodiment of the subject matter fuel injector (1) is illustrated. In said embodiment, the preload element (70) is a bolt. The actuator (11) stays between the trigger (50) and the preload element (70) provided in bolt form. As the preload element (70), provided in bolt form, is tightened, the actuator (11) is positioned under a preload as desired. Thanks to said embodiment, there remains no need to use preload spring. Thus, the production of the fuel injector is facilitated. Thanks to the preload element (70) provided in bolt form, the preload amount needed by the actuator (11) is easily adjusted.

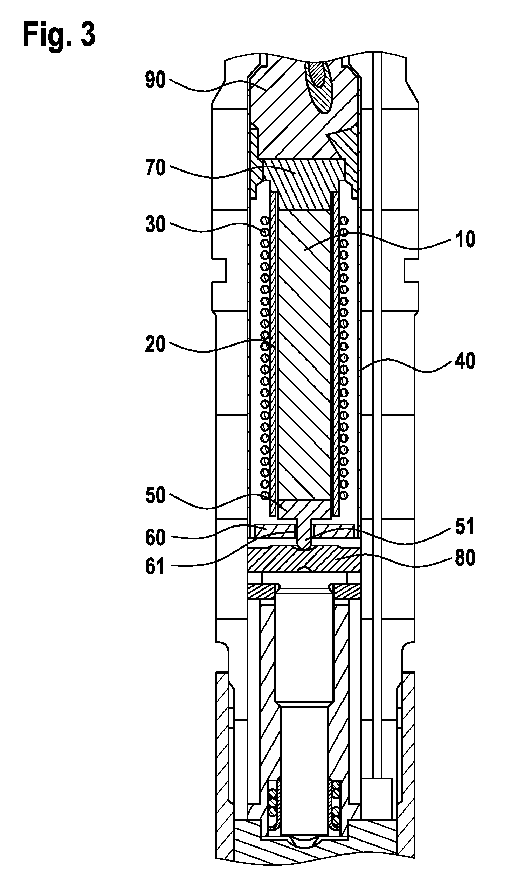

In Figure 3, another alternative embodiment of the subject matter fuel injector (1) is illustrated. In said embodiment, the guide element (60) is made of rigid material. The triggering tip (51) is movable inside the guide channel (61) provided on the guide element (60). Since the guide element (60) is made of rigid material, the production thereof is facilitated. In other words, the guide element (60) is produced so as to have a simpler geometry and by means of simpler production methods. Moreover, the number of production steps is reduced since there remains no need to connect the guide element (60) and the trigger (50) to each other.

Since actuator (11) made of magnetostrictive material of metallic origin is used in all embodiments of the subject matter fuel injector (1), a more robust fuel injector (1) is obtained.

Besides, as an actuator made (11) of magnetostrictive material requires less layers compared to a piezo actuator (down to a single layer rod), the production of the fuel injector (1) is facilitated. Moreover, a fuel injector (1) embodiment is obtained which has smaller dimensions when compared with the fuel injectors of the prior art.

The protection scope of the present invention is set forth in the annexed Claims and cannot be restricted to the illustrative disclosures given above, under the detailed description. It is because a person skilled in the relevant art can obviously produce similar embodiments under the light of the foregoing disclosures, without departing from the main principles of the present invention.

## Claims

1. A fuel injector (1) having at least one triggering mechanism (10) providing the movement of at least one trigger (50) for spraying the fuel when desired, in order to be used in internal combustion engines, **characterized in that** said triggering mechanism (10) comprises at least one magnetic field generator (30) and at least one actuator (11) made of magnetostrictive material positioned inside the magnetic field of said magnetic field generator (30).

2. A fuel injector (1) according to Claim 1, **characterized in that** said actuator (11) made of giant magnetostrictive material.

3. A fuel injector (1) according to Claim 1, **characterized in that** the actuator (11) is stopped onto the trigger (50) from one end and it is stopped onto at least one rigid member (90), provided inside the fuel injector (1), from the other end.

4. A fuel injector (1) according to Claim 1, **characterized in that** the magnetic field generator (30) is a solenoid wire.

5. A fuel injector (1) according to Claim 4, **characterized in that** the magnetic field generator element (30) at least partially wraps around the actuator (11).

6. A fuel injector (1) according to Claim 5, **characterized in that** the magnetic field generator element (30) extends along the actuator (11).

7. A fuel injector (1) according to Claim 1, **characterized in that** at least one frame (20) is provided between the magnetic field generator element (30) and the actuator (11).

8. A fuel injector (1) according to Claim 1, **characterized by** comprising at least one shell (40) wherein the actuator (11) and magnetic field generator element (30) are positioned.

9. A fuel injector (1) according to Claim 1, **characterized by** comprising at least one triggering tip (51) provided in protrusion form on the trigger (50) in order to control the movement direction of the trigger (50), and at least one guide element (60) having at least one guide channel (61) wherein said triggering tip (51) is at least partially placed.

10. A fuel injector (1) according to Claim 9, **characterized in that** the guide element (60) is provided in the vicinity of one end of the shell (40).

11. A fuel injector (1) according to Claim 10, **characterized in that** the guide element (60) is connected to the trigger (50) and it is made of flexible membrane material.

12. A fuel injector (1) according to Claim 10, **characterized in that** the guide element (60) is made of a rigid material.

13. A fuel injector (1) according to any one of the preceding claims, **characterized by** comprising at least one preload element (70) in order to provide compression of the actuator (11) at a predetermined amount.

14. A fuel injector (1) according to Claim 13, **characterized in that** the preload element (70) is at least one spring which pushes the actuator (11) towards the rigid member (90) provided inside the fuel injector (1).

15. A fuel injector (1) according to Claim 13, **characterized in that** the preload element (70) is provided in the form of a bolt positioned inside the shell (40).
